**Europäisches Patentamt**

**European Patent Office**

**Office européen des brevets**

(19)

(11) Veröffentlichungsnummer : **0 385 995 B1**

(12) # EUROPÄISCHE PATENTSCHRIFT

(45) Veröffentlichungstag der Patentschrift :
**09.12.92 Patentblatt 92/50**

(51) Int. Cl.$^5$ : **H05K 3/20**

(21) Anmeldenummer : **88905677.6**

(22) Anmeldetag : **01.07.88**

(86) Internationale Anmeldenummer :
**PCT/DE88/00403**

(87) Internationale Veröffentlichungsnummer :
**WO 89/00373 12.01.89 Gazette 89/02**

(54) **PRäGEFOLIE, INSBESONDERE HEISSPRäGEFOLIE, ZUR ERZEUGUNG VON LEITERBAHNEN AUF EINEM SUBSTRAT.**

(30) Priorität : **08.07.87 DE 3722508**

(43) Veröffentlichungstag der Anmeldung :
**12.09.90 Patentblatt 90/37**

(45) Bekanntmachung des Hinweises auf die Patenterteilung :
**09.12.92 Patentblatt 92/50**

(84) Benannte Vertragsstaaten :
**AT BE CH DE FR GB IT LI NL SE**

(56) Entgegenhaltungen :
**EP-A- 0 185 998**
**DE-A- 1 521 042**
**US-A- 2 984 597**
**US-A- 4 586 976**

(73) Patentinhaber : **LEONHARD KURZ GMBH & CO.**
**Schwabacher Strasse 482**
**W-8510 Fürth/Bayern (DE)**

(72) Erfinder : **WILD, Alfred, Heinrich**
**Erlanger Strasse 11**
**W-8510 Fürth (DE)**

(74) Vertreter : **LOUIS, PÖHLAU, LOHRENTZ & SEGETH**
**Kesslerplatz 1 Postfach 3055**
**W-8500 Nürnberg-1 (DE)**

EP 0 385 995 B1

## Beschreibung

Die Erfindung betrifft eine Prägefolie, insbesondere Heissprägefolie, zur Erzeugung von Leiterbahnen auf einem Substrat aus elektrisch isolierendem Material, welche eine Trägerfolie aufweist, die in den Bereichen, in denen keine Leiterbahnen vorgesehen sind, eine eine galvanische Ablagerung einer Metallschicht verhindernde, gegen Galvanik-Flüssigkeiten beständige Abdeckschicht und in den nicht von der Abdeckschicht bedeckten Bereichen eine von ihr ablösbare, zur Bildung der Leiterbahnen dienende Metallschicht trägt.

Es gibt verschiedene Verfahren zur Herstellung von Gegenständen, die an einer Oberfläche zumindest bereichsweise mit einer elektrisch leitenden, auf einem Substrat aus elektrisch isolierendem Material Leiterbahnen bildenden Metallschicht versehen sind.

Beispielsweise ist in der DE 32 15 205 A1 ein Verfahren zur Herstellung gedrucker Schaltungen beschrieben, bei dem die Leiterbahnen auf einer Platte aus isolierendem Material vorgesehen sind. In einem gleichen Verfahren können auch Leiterbahnen auf sonstigen Gegenständen aus Kunststoff, beispielsweise im Wege des sogenannten "Inmold"-Verfahrens, angebracht werden. Dabei wird eine Folie, die eine die Leiterbahnen bildende Metallschicht trägt, in die Form zur Herstellung des Gegenstandes eingelegt und dann mit Kunststoff hinterspritzt, so dass nach dem Entformen die Leiterbahnen auf der Oberfläche des Gegenstandes haften, während der Zwischenträger abgezogen werden kann.

Bei einem Vorgehen gemäss der DE 32 15 205 A1 wird ein Zwischenträger verwendet, bei dem eine leitfähige Anlagerungsschicht für die Metallschicht nicht allzu fest haftet, so dass nach dem Aufbringen der die Leiterbahnen bildenden Metallschicht auf das Substrat und Abziehen des Zwischenträgers die Anlagerungsschicht noch an der Metallschicht haftet. Die Anlagerungsschicht muss dann in einem Ätzvorgang entfernt werden. Ein derartiges Ätzen hat insbesondere den Nachteil, dass es nur in besonders ausgerüsteten Betrieben durchgeführt werden kann, die eine einwandfreie Entsorgung des Ätzmittels gewährleisten können. Weiterhin ist natürlich jedes Ätzverfahren mit Gefahren für die beschäftigten Personen verbunden. Schliesslich bedingen Ätzeinrichtungen einen erheblichen zusätzlichen Investitionsaufwand.

Die US-A-4 586 976 beschreibt die Herstellung von sogenannten gedruckten Schaltungen ohne Ätzvorgang der Art, dass auf einen leitenden Träger, der auch eine Folie sein kann, zuerst bereichsweise eine Abdeckschicht und dann in den freigelassenen Bereichen galvanisch eine Metallschicht aufgebracht wird.

Hierbei ist grundsätzlich auch die Möglichkeit der Verwendung einer Folie als Träger angesprochen, d.h. eine Prägefolie der gattungsgemässen Art. In diesem Zusammenhang wird jedoch darauf hingewiesen, dass bei der Handhabung einer mit Metall plattierten Folie als Träger die Gefahr besteht, dass eine Delamination der Metallschicht infolge von Biegung erfolgt, weshalb in der US-A-4 586 976 vorgeschlagen wird, die Metallplattierung und das Aufbringen der Metallschicht auf das Substrat in einem kontinuierlichen Vorgang durchzuführen. Würde man somit gemäss der US-A-4 586 976 Prägefolien herstellen, so ergäbe sich das Problem, dass diese Folien äusserst empfindlich wären, was für Prägefolien nicht zulässig ist, weil diese häufig einer sehr starken Biegebeanspruchung ausgesetzt sind. Demgegenüber wird in der US-A-4 586 976 nur die Verwendung einer Metallfolie als Trägerfolie erwähnt, wobei als Beispiel eine 0,1 mm dicke Folie aus rostfreiem Stahl genannt ist, die verhältnismässig steif ist.

In der EP-A-0 063 347 ist auf die Möglichkeit hingewiesen, in einem trockenen Verfahren bei der Herstellung von gedruckten Schaltungen zu arbeiten, wobei die Leiterbahnen aus einer auf einem Trägerband aufgebrachten Kupferfolie ausgeschnitten werden sollen, was wohl nur möglich ist, wenn das Trägerband sehr dick und die Kupferfolie vergleichsweise dünn ist. Die Herstellung einer Prägefolie auf diese Art und Weise ist äusserst umständlich. Aus diesem Grunde wird nach der EP-A-0 063 347 vorgeschlagen, eine durchgehende Kupferschicht auf dem Trägerband vorzusehen, die, um eine saubere Abtrennung bzw. Abscherung der einzelnen Leiterbahnen beim Prägen zu gewährleisten, in ganz besonderer Weise ausgebildet sein muss. Die Leiterbahnen selbst werden dann durch ein geeignetes Prägewerkzeug gebildet.

Ausgehend von dem Stand der Technik gemäss US-A-4 586 976 liegt nun der Erfindung die Aufgabe zugrunde, die bekannte Folie derart abzuwandeln, dass sie zur Verwendung als Prägefolie geeignet ist, d.h. einerseits auf den aufwendigen, umwelt- und gesundheitsgefährdenden sowie kostenintensiven Ätzvorgang verzichtet werden kann, andererseits jedoch die Folie in bei Prägefolien, insbesondere Heissprägefolien, üblicher Weise Schandhabt und verarbeitet werden kann.

Zur Lösung dieser Aufgabe wird nach der Erfindung vorgeschlagen, die Folie der eingangs erwähnten Art derart auszubilden, dass die Trägerfolie ganzflächig mit einer elektrisch leitenden Anlagerungsschicht versehen ist, die auf ihrer der Trägerfolie abgekehrten Seite einerseits die Abdeckschicht und andererseits die Metallschicht trägt, welche durch galvanische Anlagerung an der Anlagerungsschicht gebildet ist, dass die Abdeckschicht und die Metallschicht auf ihrer der Trägerfolie abgekehrten Oberfläche durch eine gemeinsame Haftschicht zur Festlegung an dem Substrat abgedeckt sind, und dass die Haftschicht aus einem Material besteht, das an der Metallschicht deutlich besser als an der Abdeckschicht haftet, die ihrerseits an der Anlage-

2

rungsschicht besser haftet als die Anlagerungsschicht im Bereich der Metallschicht an der Trägerfolie.

Eine derartige Prägefolie, insbesondere Heissprägefolie, hat gegenüber den bekannten Folien bzw. Laminaten wesentliche Vorzüge. Insbesondere lässt sich eine derartige Prägefolie mit den vorgegebenen Leiterbahnen ohne Schwierigkeiten in einem kontinuierlichen Vorgang im wesentlichen mit den von der Prägefolien-Herstellung bekannten Prozessen erzeugen. Dabei erhält man eine Folie, die in üblicher Weise entsprechend Prägefolien gehandhabt und verarbeitet werden kann. Die Aufbringung der Metallschicht auf das Substrat kann dann in einem an sich bekannten Heisspräge-Prozess geschehen, der ebenfalls kontunierlich durchgeführt werden kann, so dass die Benutzung der Prägefolie auch den Vorzug einer im wesentlichen kontunierlichen Arbeitsweise bietet. Aufgrund der entsprechenden Wahl einerseits der Haftschicht zur Festlegung der die Leiterbahnen bildenden Metallschicht auf dem Substrat und andererseits der Abdeckschicht erreicht man, dass beim Abziehen der Trägerfolie auch die Abdeckschicht mit abgezogen wird, während die die Leiterbahnen bildende Metallschicht sich von der Trägerfolie löst und an dem Substrat haftet. Bei einem derartigen Vorgehen bleibt entweder die gesamte Anlagerungsschicht auf der Trägerfolie, sofern durch entsprechende Vorbehandlung der Trägerfolie und Führung des galvanischen Verfahrens zur Anlagerung der Metallschicht eine Trennung der galvanisch gebildeten Leiterbahnen von der Anlagerungsschicht ohne grossen Kraftaufwand möglich ist, oder es wird die Anlagerungsschicht, wenn ihre Haftung gegenüber dem Zwischenträger im Bereich der galvanisch gebildeten Leiterbahnen verschlechtert ist, an den Grenzen zwischen Leiterbahnen und Abdeckschicht zerrissen, so dass die Anlagerungsschicht nur im Bereich der Abdeckschicht an der Trägerfolie verbleibt, jedoch im Bereich der Leiterbahnen mit diesen verbunden bleibt. Auf jeden Fall wird bei Verarbeitung einer Prägefolie nach der Erfindung erreicht, dass die Anlagerungsschicht zumindest im Bereich der Abdeckschicht mit der Trägerfolie entfernt wird, somit zwischen den Leiterbahnen durch die Anlagerungsschicht keine elektrischen Kontakte mehr vorhanden sind, was bedeutet, dass auf den bisher üblichen Ätzvorgang vollständig verzichtet werden kann, so dass sämtliche Probleme, die die bisherigen Ätzverfahren mit sich brachten, in einfacher Weise vermieden sind. Die gewünschte Wirkung hinsichtlich Haftfestigkeit bzw. Ablösung von Metallschicht einerseits und Abdeckschicht andererseits gegenüber der Trägerfolie bzw. dem Substrat lassen sich für den Fachmann ohne grössere Probleme durch Wahl entsprechender Werkstoffe bzw. Werkstoff-Zusammensetzungen erzielen. Dem Fachmann sind beispielsweise Haftschicht-Klassen, d.h. im wesentlichen Kleber, bekannt, die einerseits an einer Metallschicht gut haften, andererseits jedoch mit bestimmten Abdecklacken, die für die Zwecke der Erfindung gut einsetzbar sind, keine besonders feste Bindung eingehen.

Als Anlagerungsschicht wird im allgemeinen günstigerweise eine dünne, z.B. durch Sputtern oder Aufdampfen aufgebrachte Metallschicht verwendet werden. Für bestimmte Anwendungsfälle kann es jedoch auch zweckmässig sein, wenn als Anlagerungsschicht eine dünne Schicht eines aktivierten Lackes aufgebracht wird, weil sich dann beispielsweise ein Lack verwenden lässt, der eine sehr gute Haftung einerseits mit der Trägerfolie und andererseits mit der Abdeckschicht ergibt, jedoch vor allem durch das galvanische Verfahren zur Aufbringung der Metallschicht so beeinflusst werden kann, dass sich beim Übertragen der Leiterbahnen auf das Substrat die die Leiterbahnen bildende Metallschicht dann leicht von der Anlagerungsschicht löst.

Als Trägerfolie können die unterschiedlichsten Materialien verwendet werden, wenn sie nur gewährleisten, dass die Anlagerungsschicht auf ihnen hinreichend fest haftet. Besonders günstig ist es jedoch, wenn eine Kunststoff-Folie, vorzugsweise eine Polyester-Folie, verwendet wird, weil eine derartige Folie einerseits die verlangten Eigenschaften hinsichtlich der Haftfestigkeit der Anlagerungsschicht aufweist, andererseits das die Leiterbahnen bildende Gebilde sehr gut herstellbar und speicherbar ist. Beispielsweise können bei Ausbildung als Heissprägefolie die Anlagerungsschicht in einem üblichen Aufdampf- bzw. Lackierverfahren und die Abdeckschicht durch Lackieren aufgebracht werden.

Es ist nach der Erfindung weiter vorgesehen, dass zwischen Anlagerungsschicht und Trägerfolie gegebenenfalls nur bereichsweise eine Zwischenschicht vorgesehen ist. Diese Zwischenschicht kann beispielsweise nur im Bereich der späteren Abdeckschicht vorgesehen sein, in welchem Falle man dann eine Zwischenschicht verwenden muss, durch die die Haftung der Anlagerungsschicht an dem Zwischenträger verbessert wird. Eine andere Möglichkeit besteht darin, die Zwischenschicht in den später die Leiterbahnen tragenden Bereichen des Zwischenträgers aufzubringen. In diesem Falle muss eine Zwischenschicht verwendet werden, durch die die Haftung der Anlagerungsschicht auf dem Zwischenträger vermindert wird, beispielsweise eine geeignete Wachsschicht.

Für die Haftschicht können verschiedene Kleber verwendet werden. Besonders zweckmässig ist es jedoch, wenn die Haftschicht von einem heissiegelfähigen Kleber gebildet ist, weil ein derartiger Kleber eine Handhabung des die Leiterbahn tragenden Laminates vor Übertragung der Leiterbahnen auf das Substrat gestattet, ohne dass die Gefahr der Verklebung bestünde, jedoch andererseits heissiegelfähige Kleber bekannt sind, die die erforderlichen Eigenschaften hinsichtlich der Haftung gegenüber den Leiterbahnen einerseits und der mangelhaften Verbindung mit der Abdeckschicht andererseits hervorragend vereinen.

Die Abdeckschicht muss selbstverständlich in ihren Eigenschaften so gewählt werden, dass sie durch das galvanische Verfahren zur Bildung der Leiterbahnen in keiner Weise beeinträchtigt wird. Dies lässt sich sehr einfach dadurch erreichen, dass die Abdeckschicht von einem isolierenden Lack gebildet wird. Eine andere Möglichkeit besteht darin, als Abdeckschicht ein Wachs, insbesondere ein modifiziertes Montan- und/oder Polyolefin-Wachs zu verwenden. Derartige Wachse schmelzen bei Hitzeeinwirkung. Selbst wenn in einem derartigen Fall die Haftschicht vergleichsweise gut an der Abdeckschicht haften sollte, wird beim Übertragen der Leiterbahnen von dem Laminat auf das Substrat unter Zwischenschaltung der Haftschicht eine zuverlässige Trennung der Anlagerungsschicht im Bereich der Abdeckschicht von der Haftschicht bzw. dem Substrat erreicht, nämlich durch eventuelles Schmelzen der Abdeckschicht, wenn sich die Abdeckschicht nicht ohnehin von der Haftschicht lösen sollte.

Versuche haben gezeigt, dass die angestrebten Wirkungen sehr gut erreichbar sind, wenn für die Abdeckschicht ein Lack aus der Stoffklasse der Polyurethane, Polyamidharze und/oder Siliconharze und für die Haftschicht ein heissklebefähiges Material aus der Klasse der Polyesterharze, Polyvinylchloride und/oder modifizierten Acrylharze verwendet wird. Bei Wahl dieser Substanzen ist gewährleistet, dass Abdeckschicht und Haftschicht nur wenig, Haftschicht und Leiterbahnen bzw. Metallschicht dagegen sehr gut aneinander haften, so dass die Trennung beim Übertragen der Leiterbahnen auf das Substrat zuverlässig gewährleistet ist.

Während bisher im allgemeinen davon ausgegangen wurde, dass die Anlagerungsschicht bei Übertragung der Leiterbahnen auf das Substrat unterteilt wird und im Bereich der Leiterbahnen mit auf das Substrat gelangt, kann unter Umständen ein vollständiges Verbleiben der Anlagerungsschicht auf der Trägerfolie erreicht werden, wenn in den nicht von der Abdeckschicht bedeckten Bereichen zwischen der Metallschicht und der Anlagerungsschicht eine dünne, metallische Trennschicht, z.B. aus Silber, vorgesehen ist. Derartige Trennschichten sind z.B. von Elektroformverfahren her grundsätzlich bekannt. Die Verwendung einer Silberschicht als Trennschicht hat dabei den Vorteil, dass die Kontaktierung der die Leiterbahnen bildenden Metallschicht erleichert bzw. verbessert wird.

Weitere Merkmale, Einzelheiten und Vorteile der Erfindung ergeben sich aus der folgenden Beschreibung von Ausführungsbeispielen der Prägefolie anhand der Zeichnung.

In dieser zeigen -:

Figuren 1 bis 3 eine Prägefolie nach der Erfindung in unterschiedlichen Herstellungsstadien, und

Figur 4 die sich bei Anbringung von Leiterbahnen auf einem Substrat unter Verwendung einer Prägefolie nach der Erfindung ergebende Konfiguration.

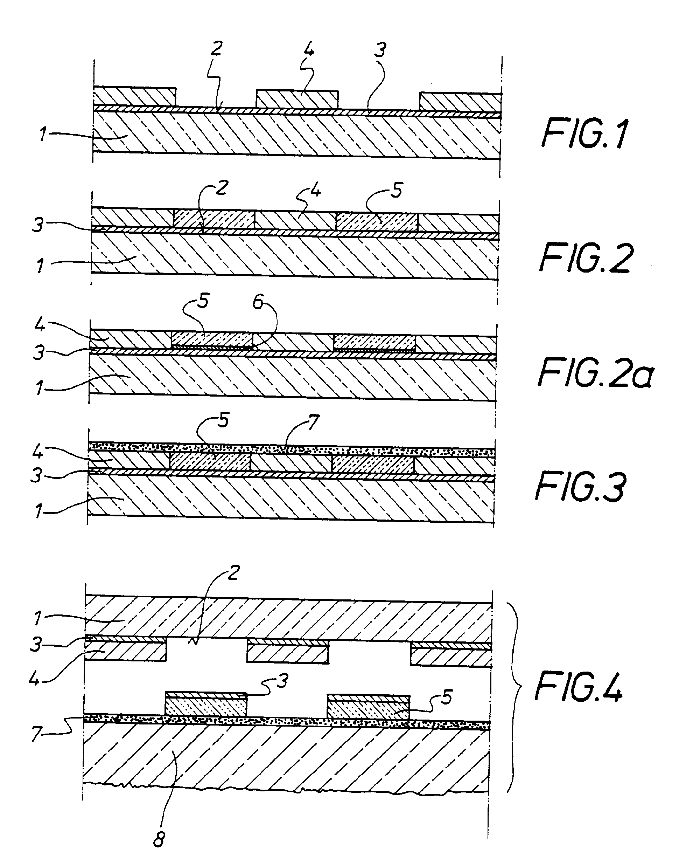

Die in den Figuren 1 bis 3 gezeigte Prägefolie umfasst eine Trägerfolie 1. Es handelt sich abei um einen der bei Prägefolien üblichen Träger, z.B. eine Polyester-Folie einer Dicke von etwa 23 $\mu$m. Die Trägerfolie 1 trägt auf ihrer Oberfläche 2 ganzflächig eine Anlagerungsschicht 3 aus elektrisch leitendem Material, beispielsweise eine im Hochvakuum aufgedampfte Kupferschicht einer Dicke von 50 bis 100 nm. Um eine besonders gute Haftung der Anlagerungsschicht 3 auf der Trägerfolie 1 zu erreichen, wird zweckmässig die Oberfläche 2 der Trägerfolie 1 vor dem Aufdampfen der Anlagerungsschicht 3 einer Koronaentladungs-Behandlung unterzogen.

Die Anlagerungsschicht 3 muss nicht unbedingt aus einer Metallschicht bestehen. Es wäre beispielsweise auch denkbar, als Anlagerungsschicht 3 eine andere Schicht zu verwenden, die eine galvanische Anlagerung von Metall gestattet, beispielsweise eine Schicht eines entsprechend aktivierten Lackes. Die Verwendung eines Lackes als Anlagerungsschicht 3 bietet dabei die Möglichkeit, die Hafteigenschaften der Anlagerungsschicht 3 gegenüber der Trägerfolie 1 einerseits sowie gegenüber den auf der anderen Seite der Anlagerungsschicht 3 anschliessenden Materialien in gewissem Umfange einzustellen.

Bei der Herstellung der Prägefolie für die Zwecke der Erfindung wird, wie aus Figur 1 ersichtlich, auf die Anlagerungsschicht 3 dann in den Bereichen, die später keine Leiterbahnen aufweisen sollen, eine Abdeckschicht 4 aufgebracht. Die Abdeckschicht 4 soll die Eigenschaft haben, dass sie an der Anlagerungsschicht 3, beispielsweise einer aufgedampften Metallschicht, sehr gut haftet. Als Abdeckschicht 4 werden bevorzugt isolierende Lacke aus der Stoffklasse der Polyurethane, Polyamidharze und/oder Silikonharze verwendet. Eine andere Möglichkeit ist die, als Abdeckschicht ein Wachs, insbesondere ein modifiziertes Montan- und/oder Polyolefin-Wachs zu verwenden. Die Verwendung von Wachsen bietet bei dem Einsatz der Folie im Heissprägeverfahren den Vorteil, dass der Schmelzpunkt des Wachses so eingestellt werden kann, dass eine zuverlässige Trennung gewährleistet ist.

Nach dem Aufbringen der Abdeckschicht 4 gemäss Figur 1 wird die Trägerfolie 1 mit der Anlagerungsschicht 3, die in den Bereichen zwischen der Abdeckschicht 4 frei liegt, einem galvanischen Verfahren unterzogen, in welchem auf der Anlagerungsschicht 3 dort, wo diese nicht durch die Abdeckschicht 4 verdeckt ist, galvanisch weiteres Metall zur Bildung der später die Leiterbahnen ergebenden Metallschicht 5 abgelagert wird. Bei der Ausführungsform der Figur 2 erfolgt die Anlagerung des die Metallschicht 5 bildenden Metalls direkt anschliessend an die Aufbringung der Abdeckschicht 4.

Die Ausführungsform gemäss Figur 2a unterscheidet sich von der gemäss Figur 2 dadurch, dass vor der Anlagerung der Metallschicht 5 erst auf der Anlagerungsschicht 3 galvanisch eine Trennschicht 6, beispielsweise eine dünne Silberschicht, gebildet wird. Die Verwendung derartiger Trennschichten ist beispielsweise von Elektroformverfahren her bekannt. Diese Trennschichten haben die Aufgabe, eine leichte Ablösung der galvanisch gebildeten Schicht 5 von der Anlagerungsschicht 3 zu ermöglichen. Wenn eine derartige Trennschicht 6 nicht vorhanden ist, wird im allgemeinen durch die galvanische Behandlung der Anlagerungsschicht 3 zur Abscheidung der Metallschicht 5 die durch die Koronaentladungs-Behandlung ursprünglich verbesserte Haftung der Anlagerungsschicht 3 auf der Trägerfolie 1 wieder aufgehoben, so dass sich die meist metallische Anlagerungsschicht 3 im Bereich unter der galvanisch gebildeten Metallschicht 5 relativ leicht von der Trägerfolie 1 ablösen lässt.

Nach dem Aufbringen der Abdeckschicht 4 und der galvanischen Bildung der Metallschicht 5 auf der Trägerfolie 1 mit der Anlagerungsschicht 3 wird dann die Prägefolie durch Aufbringung einer Haftschicht 7, beispielsweise einer Heissklebeschicht, auf die freie Oberfläche der Anlagerungsschicht 4 sowie der Metallschicht 5 vervollständigt. Diese Haftschicht muss derart ausgebildet sein, dass sie eine sehr gute Haftung gegenüber der Metallschicht 5 zeigt, dagegen auf der Abdeckschicht 4 nur sehr schlecht oder überhaupt nicht haftet. Hierdurch soll erreicht werden, dass bei Übertragung der Metallschicht 5 auf das Substrat die Metallschicht 5 über die Haftschicht 7 sehr gut an das Substrat gebunden wird, während die Abdeckschicht 4 keine oder nur eine sehr geringe Verbindung mit dem Substrat erfährt, so dass beim Abziehen der als Zwischenträger dienenden Trägerfolie 1 die Abdeckschicht 4 und zumindest in ihrem Bereich die Anlagerungschicht 3 von dem Substrat entfernt werden, während die Metallschicht 5 und ggf. im Bereich der Metallschicht 5 die Anlagerungsschicht 3 auf dem Substrat verbleibt und die Leiterbahnen bildet.

Dieser Vorgang ist in Figur 4 gezeigt. In der oberen Hälfte von Figur 4 ist die Trägerfolie 1 der Prägefolie mit Teilen der Anlagerungsschicht 3 sowie der Abdeckschicht 4 dargestellt. Die untere Hälfte der Figur 4 zeigt, dass auf dem Substrat 8 mittels der Haftschicht 7 die die Leiterbahnen bildende Metallschicht 5 und auf dieser die entsprechenden Bereiche der Anlagerungsschicht 3 festgelegt sind.

Wenn bei Herstellung des Gebildes gemäss Figur 4 nicht eine Prägefolie entsprechend der Ausführungsform der Figuren 2 und 3 verwendet wird, sondern eine Prägefolie, bei der gemäss Figur 2a auf der Anlagerungsschicht 3 noch eine Trennschicht 6 zur Ablösung der Metallschicht 5 vorgesehen ist, erhält man nach dem Abprägen auf dem Substrat 8 lediglich eine Metallschicht 5. Die Anlagerungsschicht 3 verbleibt dagegen insgesamt auf der Trägerfolie 1, weil die Trennschicht 6 eine Trennung zwischen Metallschicht 5 und Anlagerungsschicht 3 begünstigt. Vor allem bei Verwendung einer Trennschicht kann dann auch eine Abdeckschicht 4 eingesetzt werden, die beispielsweise durch Erweichung infolge Erhitzens oder durch geringe mechanische Festigkeit in etwa parallel zur Oberfläche der Trägerfolie 1 zerreisst. Es spielt ja keine Rolle, wenn auf der Haftschicht 7 zwischen den die Leiterbahnen bildenden Bereichen der Metallschicht 5 noch etwas Abdeckschicht 4 vorhanden ist, sofern die Abdeckschicht 4 nur isolierend ist. Wesentlich ist nur, dass zwischen den die Leiterbahnen bildenden Bereichen der Metallschicht 5 keine leitende Verbindung durch die Anlagerungsschicht 3 vorhanden ist.

Nachstehend wird ein Beispiel für die Herstellung einer Prägefolie nach der Erfindung beschrieben -:

Im ersten Verfahrensschritt wird eine Polyester-Folie einer Stärke von etwa 23 $\mu$m auf ihrer Oberfläche 2 einer Koronaentladungs-Behandlung unterzogen.

Auf die entsprechend behandelte Oberfläche 2 der Polyester-Folie 1 wird dann in an sich bekannter Weise Kupfer im Hochvakuum in einer Schichtdicke von 50 bis 100 nm zur Bildung der Anlagerungsschicht 3 aufgedampft.

Die so mit einer Metallschicht als Anlagerungsschicht 3 versehene Trägerfolie 1 wird hieran anschliessend mit der Abdeckschicht 4 in Form einer Negativmaske versehen. Hierzu wird beispielsweise folgender Lack in einem üblichen Druckverfahren mit einem Flächengewicht von 5 bis 10 g/m$^2$ aufgetragen -:

|  | Gewichtsanteile |
|---|---|
| Äthylacetat | 350 |
| Methyläthylketon | 300 |
| hydrofunkt. Acrylharz (5-10 % Hydroxylgruppengehalt) | 150 |
| aromat. Isocyanat (5-10 % NCO-Gruppengehalt) | 200 |

Nach Aushärten des aufgedruckten Lackes wird zur Bildung der Folie gemäss Figur 2 durch kathodische Verstärkung in einem sauren Elektrolytbad die Metallschicht 5 ausgebildet. Hierzu kann z.B. ein Bad folgender Zusammensetzung verwendet werden -:

|  | Gewichtsanteile |
|---|---|
| $H_2O$ Dest. | 1000 |
| Cu $SO_4$ | 50 |
| $H_2SO_4$ (98 %ig) | 10 |
| L-Ascorbinsäure | 5 |

Durch elektrolytische Verstärkung kann man eine Schichtdicke für die die Leiterbahnen repräsentierende Metallschicht von 7 bis etwa 50 μm erreichen. Wird mit nachstehenden Bedingungen gearbeitet, erhält man bei Verwendung von Kupfer eine Stärke von 10 bis 14 μm.

| Abscheidespannung | 1,5 V |
|---|---|
| Stromdichte | ca. 5 bis 7 mA/cm² |
| Abscheidedauer | ca. 20 bis 30 Minuten |
| Bad-Temperatur | 35 °C |

In diesem Zusammenhang ist darauf hinzuweisen, dass die Dicke der Metallschicht 5 umso grösser wird, je höher die Stromdichte, Abscheidespannung und Abscheidedauer sind. Es muss allerdings Vorsorge dafür getroffen werden, dass nicht mit zu hoher Stromdichte gearbeitet wird, um eine Zerstörung der Anlagerungsschicht 3 zu verhindern. Wenn diese Voraussetzungen berücksichtigt werden, ist die Kontaktierung sehr einfach, weil ja nur generell die Anlagerungsschicht 3, die sich im wesentlichen über die gesamte Fläche der Trägerfolie 1 erstreckt, kontaktiert werden muss. Es kann beispielsweise bei Herstellung einer Prägefolie nach der Erfindung ohne Probleme kontinuierlich, d.h. im Durchlauf der Trägerfolie 1 mit der Anlagerungsschicht 3 durch ein Bad, gearbeitet werden.

Nach dem Verlassen des galvanischen Bades folgt eine Reinigung der Trägerfolie 1 mit den diversen Schichten, beispielsweise durch eine neutralisierende Flüssigkeit und/oder destilliertes Wasser. Anschliessend wird getrocknet. Auch diese Vorgänge lassen sich ohne Schwierigkeiten kontinuierlich durchführen.

Nach der Reinigung und Trocknung wird dann auf die freie Oberfläche der Abdeckschicht 4 bzw. Metallschicht 5 noch eine heissiegelfähige Klebeschicht 7 aufgebracht, und zwar mit einem Flächengewicht von 0,5 bis 3,00 g/m², wobei folgender Kleber verwendet werden kann -:

|  | Gewichtsanteile |
|---|---|
| Methyläthylketon | 800 |
| linearer thermoplast. Copolyester | 200 |

Nach Trocknung bzw. Aushärtung des Klebers ist die Prägefolie fertiggestellt. Sie kann dann in einem üblichen Prägeverfahren auf ein isolierendes Substrat, beispielsweise zur Bildung einer Leiterplatte übertragen oder im sogenannten "Inmold"-Verfahren, d.h. durch Einlegen in eine Spritzgiessform und Hinterspritzen, auf die Oberfläche eines gespritzten Gegenstandes aufgebracht werden. Nach der Aufbringung der Metallschicht 5 mittels der Haftschicht 7 auf die Oberfläche des Substrates wird dann in der bereits erläuterten Weise die Trägerfolie 1 mit der Anlagerungsschicht 3 abgezogen, worauf man dann ohne weitere Nachbehandlung einen Gegenstand erhält, der an seiner Oberfläche mit Leiterbahnen, z.B. zur Bildung einer gedruckten Schaltung, versehen ist.

Eine Abwandlung des vorstehend erläuterten Ausführungsbeispieles besteht darin, dass vor der Abscheidung der Metallschicht 5 unter den allgemein aus Elektroformverfahren bekannten Bedingungen auf der Anlagerungsschicht 3 eine dünne Silber-Trennschicht 6 abgelagert wird. In diesem Falle kann man als Abdeckschicht 4 nicht nur, wie bei dem vorstehend erläuterten Ausführungsbeispiel, einen Lack, sondern auch modifizierte Montan- und/oder Polyolefin-Wachse, d.h. Wachse, die einerseits gegen galvanische Bäder beständig sind, andererseits jedoch eine leichte Ablösung zur Erzielung der erfindungsgemäss angestrebten Wirkung gewährleisten.

**Patentansprüche**

1. Prägefolie, insbesondere Heissprägefolie zur Erzeugung von Leiterbahnen auf einem Substrat (8) aus elektrisch isolierendem Material, welche eine Trägerfolie (1) aufweist, die in den Bereichen, in denen keine Leiterbahnen vorgesehen sind, eine eine galvanische Ablagerung einer Metallschicht (5) verhindernde, gegen Galvanik-Flüssigkeiten beständige Abdeckschicht (4) und in den nicht von der Abdeckschicht (4) bedeckten Bereichen eine von ihr ablösbare, zur Bildung der Leiterbahnen dienende Metallschicht (5) trägt,
**dadurch gekennzeichnet,**
dass die Trägerfolie (1) ganzflächig mit einer elektrisch leitenden Anlagerungsschicht (3) versehen ist, die auf ihrer der Trägerfolie (1) abgekehrten Seite einerseits die Abdeckschicht (4) und andererseits die Metallschicht (5) trägt, welche durch galvanische Anlagerung an der Anlagerungsschicht (3) gebildet ist, dass die Abdeckschicht (4) und die Metallschicht (5) auf ihrer der Trägerfolie (1) abgekehrten Oberfläche durch eine gemeinsame Haftschicht (7) zur Festlegung an dem Substrat (8) abgedeckt sind, und dass die Haftschicht (7) aus einem Material besteht, das an der Metallschicht (5) deutlich besser als an der Abdeckschicht (4) haftet, die ihrerseits an der Anlagerungsschicht (3) besser haftet als die Anlagerungsschicht (3) im Bereich der Metallschicht (5) an der Trägerfolie (1).

2. Prägefolie nach Anspruch 1,
**dadurch gekennzeichnet,**
dass die Anlagerungsschicht (3) eine dünne, z.B. durch Sputtern oder Aufdampfen aufgebrachte Metallschicht ist.

3. Prägefolie nach Anspruch 1,
**dadurch gekennzeichnet,**
dass die Anlagerungsschicht (3) eine dünne Schicht eines galvanisch metallisierbaren Lackes ist.

4. Prägefolie nach einem der Ansprüche 1 bis 3,
**dadurch gekennzeichnet,**
dass zwischen Anlagerungsschicht (3) und Trägerfolie (1), ggf. nur bereichsweise, eine Zwischenschicht vorgesehen ist.

5. Prägefolie nach einem der Ansprüche 1 bis 4,

**dadurch gekennzeichnet**,
dass die Haftschicht (7) von einem heissiegelfähigen Kleber gebildet ist.

6. Prägefolie nach einem der Ansprüche 1 bis 5,
**dadurch gekennzeichnet**,
dass die Abdeckschicht (4) von einem isolierenden Lack gebildet ist.

7. Prägefolie nach einem der Ansprüche 1 bis 5,
**dadurch gekennzeichnet**,
dass die Abdeckschicht (4) von einem Wachs, insbesondere einem modifizierten Montan- und/oder Polyolefin-Wachs gebildet ist.

8. Prägefolie nach einem der Ansprüche 1 bis 6,
**dadurch gekennzeichnet**,
dass die Abdeckschicht (4) von einem Lack aus der Stoffklasse der Polyurethane, Polyamidharze und/oder Silikonharze und die Haftschicht (7) von einem heissklebefähigen Material aus der Klasse der Polyesterharze, Polyvinylchloride und/oder modifizierten Acrylharze gebildet sind.

9. Prägefolie nach einem der Ansprüche 1 bis 8,
**dadurch gekennzeichnet**,
dass in den nicht von der Abdeckschicht (4) bedeckten Bereichen zwischen der Metallschicht (5) und der Anlagerungsschicht (3) eine dünne, metallische, galvanisch abgelagerte Trennschicht (6), z.B. aus Silber, vorgesehen ist.

## Claims

1. Embossing sheet, in particular hot-embossing sheet for producing conductor tracks on a substrate (8) composed of electrically insulating material, which embossing sheet comprises a backing sheet (1) which carries a masking layer (4) which prevents an electro-deposition of a metal layer (5) and is resistant to electroplating liquids in those regions in which no conductor tracks are planned, and a metal layer (5) which is detachable from the backing sheet and which serves to form the conductor tracks in those regions not covered by the masking layer (4), characterised in that the entire surface of the backing sheet (1) is provided with an electrically conducting plating-base layer (3) which carries, on its side remote from the backing sheet (1), the masking layer (4), on the one hand, and the metal layer (5), on the other hand, which metal layer has been formed by electrodeposition on the plating-base layer (3), in that the masking layer (4) and the metal layer (5) are coated, on their surface remote from the backing sheet (1), with a common adhesive layer (7) for attachment to the substrate (8), and in that the adhesive layer (7) is composed of a material which adheres to the metal layer (5) markedly better than to the masking layer (4), which, in turn, adheres better to the plating-base layer (3) than the plating-base layer (3) adheres to the backing sheet (1) in the region of the metal layer (5).

2. Embossing sheet according to Claim 1, characterised in that the plating-base layer (3) is a thin metal layer applied, for example, by sputtering or vapour deposition.

3. Embossing sheet according to Claim 1, characterised in that the plating-base layer (3) is a thin layer of a lacquer which can be metallised by electro-plating.

4. Embossing sheet according to one of Claims 1 to 3, characterised in that an interlayer is provided between plating-base layer (3) and backing sheet (1), optionally only in certain regions.

5. Embossing sheet according to one of Claims 1 to 4, characterised in that the adhesive layer (7) is formed by a heat-sealing adhesive.

6. Embossing sheet according to one of Claims 1 to 5, characterised in that the masking layer (4) is formed by an insulating lacquer.

7. Embossing sheet according to one of Claims 1 to 5, characterised in that the masking layer (4) is formed by a wax, in particular a modified montan and/or polyolefin wax.

8. Embossing sheet according to one of Claims 1 to 6, characterised in that the masking layer (4) is formed by a lacquer from the substance class comprising the polyurethanes, polyamide resins and/or silicone resins and the adhesive layer (7) is formed from a heat-sealing material from the class comprising the polyester resins, polyvinyl chlorides and/or modified acrylic resins.

9. Embossing sheet according to one of Claims 1 to 8, characterised in that a thin metallic electrodeposited release layer (6) composed, for example, of silver is provided between the metal layer (5) and the plating-base layer (3) in the regions not covered by the masking layer (4).

**Revendications**

1. Feuille d'estampage, en particulier feuille d'estampage à chaud pour la production de pistes conductrices sur un substrat (8) en matière électriquement isolante, présentant une feuille porteuse (1) qui porte dans les zones dans lesquelles aucune piste conductrice n'est prévue une couche de recouvrement (4) empêchant un dépôt galvanique d'une couche métallique (5) et résistant aux liquides de galvanisation et qui porte dans les zones non recouvertes par la couche de recouvrement (1) une couche métallique (5) qui peut en être détachée et qui sert à la formation des pistes conductrices, caractérisée en ce que la feuille porteuse (1) est pourvue sur toute la surface d'une couche de fixation (3) électriquement conductrice qui porte sur son côté tourné à l'écart de la feuille porteuse (1) d'une part la couche de recouvrement (4) et d'autre part la couche métallique (5) formée par dépôt galvanique sur la couche de fixation (3), en ce que la couche de recouvrement (4) et la couche métallique (5) sont recouvertes sur leur surface tournée à l'écart de la feuille porteuse (1) par une couche adhésive (7) commune pour la fixation sur le substrat (8) et en ce que la couche adhésive (7) est constituée par une matière qui adhère nettement mieux à la couche métallique (5) qu'à la couche de recouvrement (4) qui de son côté adhère mieux à la couche de fixation (3) que la couche de fixation (3) n'adhère à la feuille porteuse (1) dans la zone de la couche métallique (5).

2. Feuille d'estampage suivant la revendication 1, caractérisée en ce que la couche de fixation (3) est une mince couche métallique appliquée par exemple par pulvérisation ou par métallisation sous vide.

3. Feuille d'estampage suivant la revendication 1, caractérisée en ce que la couche de fixation (3) est une mince couche d'une laque qui peut être métallisée par galvanisation.

4. Feuille d'estampage suivant l'une quelconque des revendications 1 à 3, caractérisée en ce qu'entre couche de fixation (3) et feuille porteuse (1) est prévue, le cas échéant uniquement par zone, une couche intermédiaire.

5. Feuille d'estampage suivant l'une quelconque des revendications 1 à 4, caractérisée en ce que la couche adhésive (7) est formée par un adhésif thermosoudable.

6. Feuille d'estampage suivant l'une quelconque des revendications 1 à 5, caractérisée en ce que la couche de recouvrement (4) est formée par une laque isolante.

7. Feuille d'estampage suivant l'une quelconque des revendications 1 à 5, caractérisée en ce que la couche de recouvrement (4) est formée par une cire, en particulier par une cire de polyoléfine et/ou minérale modifiée.

8. Feuille d'estampage suivant l'une quelconque des revendications 1 à 6, caractérisée en ce que la couche de recouvrement (4) est formée par une laque de la classe de matière des polyuréthannes, des résines de polyamide et/ou des résines de silicone et la couche adhésive (7) par une matière thermoadhésive de la classe des résines de polyester, des chlorures de polyvinyle et/ou des résines acryliques modifiées.

9. Feuille d'estampage suivant l'une quelconque des revendications 1 à 8, caractérisée en ce qu'une mince couche de séparation métallique (6) déposée par galvanisation, par exemple en argent, est prévue entre la couche métallique (5) et la couche de fixation (3) dans les zones non recouvertes par la couche de recouvrement (4).

*FIG.1*

*FIG.2*

*FIG.2a*

*FIG.3*

*FIG.4*